# EUROPEAN PATENT SPECIFICATION

(11) **EP 1 460 714 B1**
(45) Date of publication and mention of the grant of the patent: **31.05.2006**
(21) Application number: 04005282.1
(22) Date of filing: 05.03.2004
(51) Int. Cl.: H01Q 1/24, H03D 7/16, H04B 1/18, H04H 1/00

(54) **Down converter for satellite broadcast reception**
Frequenzumsetzer für Satellitenrundfunkempfang
Convertisseur de fréquence pour récepteur de la radiodiffusion par satellites

(30) Priority: 20.03.2003 JP 2003076938
(43) Date of publication of application: 22.09.2004
(73) Proprietor: ALPS ELECTRIC CO., LTD., Tokyo 145-8501 (JP)
(72) Inventor: Koike, Kiyoshi, Otsuka-cho Ota-ku Tokyo, 145-8501 (JP); Kogasaka, Yoshinori, Otsuka-cho Ota-ku Tokyo, 145-8501 (JP)
(74) Representative: Klunker . Schmitt-Nilson . Hirsch

(56) References cited:
- EP-A- 1 024 613
- EP-A- 1 050 920
- LANGE W: "ASTRA - GUT INS BILD GESETZT" FUNKSCHAU, FRANZIS-VERLAG K.G. MUNCHEN, DE, vol. 60, no. 24, 18 November 1988 (1988-11-18), pages 54-56, XP000026861 ISSN: 0016-2841
- PATENT ABSTRACTS OF JAPAN vol. 2003, no. 04, 2 April 2003 (2003-04-02) & JP 2002 374180 A (ALPS ELECTRIC CO LTD), 26 December 2002 (2002-12-26)

## Description

### BACKGROUND OF THE INVENTION

### 1. Field of the Invention

The present invention relates to down converters for satellite broadcasting, and more particularly to a two-input two-output down converter for satellite broadcast reception.

### 2. Description of the Related Art

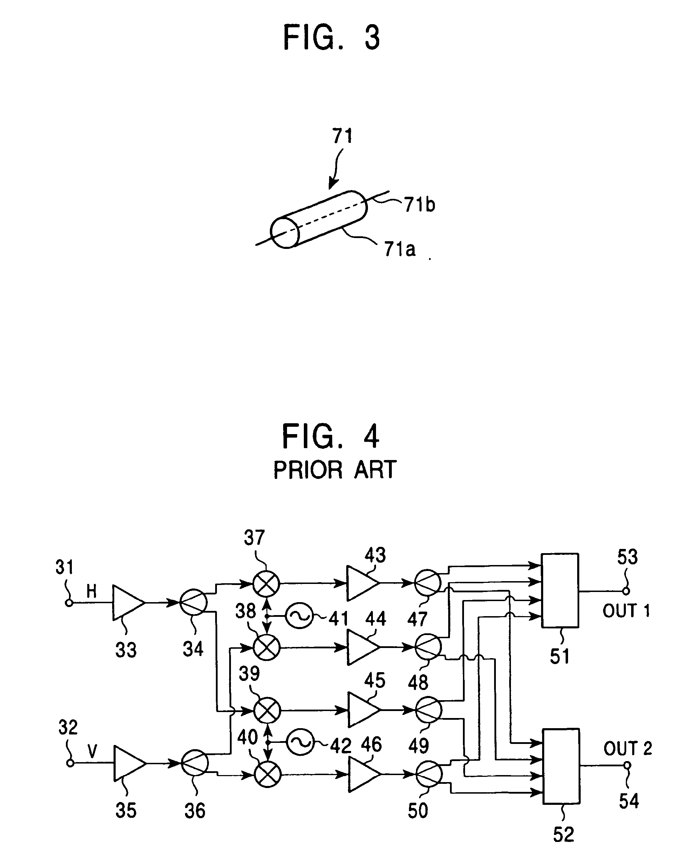

Fig. 4 is a circuit diagram of a down converter for satellite broadcast reception of the related art. Out of the satellite broadcasting signals in the 10.7 GHz to 12.75 GHz band received by a parabolic antenna (not shown), a horizontally-polarized satellite broadcasting signal is input to a first input terminal 31. A vertically-polarized satellite broadcasting signal is input to a second input terminal 32.

The first input terminal 31 is connected with a first low-noise amplifier 33, and the output terminal of the first low-noise amplifier 33 is connected with a first splitter 34. The second input terminal 32 is connected with a second low-noise amplifier 35, and the output terminal of the second low-noise amplifier 35 is connected with a second splitter 36. One horizontally-polarized satellite broadcasting signal, which is split by the first splitter 34, is input to a first mixer 37, and the other is input to a third mixer 39. One vertically-polarized satellite broadcasting signal, which is split by the second splitter 36, is input to a second mixer 38, and the other is input to a fourth mixer 40.

A first local oscillation signal of 9.75 GHz output from a first local oscillator 41 is input to both the first and second mixers 37 and 38, and a second local oscillation signal of 10.6 GHz output from a second local oscillator 42 is input to both the third and fourth mixers 39 and 40. In the first mixer 37, a horizontally-polarized satellite broadcasting signal in a low-frequency region (10.7 GHz to 11.7 GHz) of the 10.7 GHz to 12.75 GHz band described above is frequency-converted into a first intermediate-frequency (IF) signal ranging from 0.95 GHz to 1.95 GHz. Also, in the second mixer 38, a vertically-polarized satellite broadcasting signal in a low-frequency region (10.7 GHz to 11.7 GHz) is frequency-converted into a second IF signal ranging from 0.95 GHz to 1.95 GHz.

In the third mixer 39, a horizontally-polarized satellite broadcasting signal in a high-frequency region (11.7 GHz to 12.75 GHz) is frequency-converted into a third IF signal ranging from 1.1 GHz to 2.15 GHz. Also, in the fourth mixer 40, a vertically-polarized satellite broadcasting signal in a high-frequency region (11.7 GHz to 12.75 GHz) is frequency-converted into a fourth IF signal ranging from 1.1 GHz to 2.15 GHz.

The first through fourth IF signals pass through bandpass filters (not shown), and are input to first through fourth IF amplifiers 43 through 46, respectively. The output terminals of the first through fourth IF amplifiers 43 through 46 are connected with third through sixth splitters 47 through 50, respectively. One of each of the first through fourth IF signals respectively output from the splitters 47 through 50 is input to a first signal selector 51, and the other is input to a second signal selector 52.

The first signal selector 51 selects one of the first through fourth input IF signals, and outputs the selected signal to a first output terminal 53. The second signal selector 52 selects one of the first through fourth input IF signals, and outputs the selected signal to a second terminal 54. The output terminals 53 and 54 are connected to an indoor receiver (not shown) via a cable (see, for example, Japanese Unexamined Patent Application Publication No. 2002-374180 (Fig. 5)).

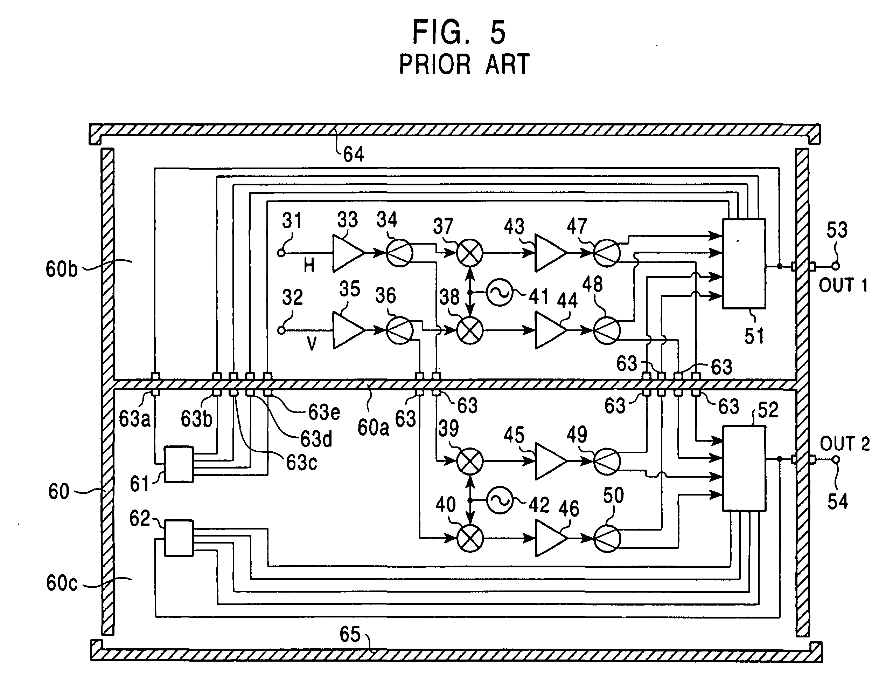

The circuit shown in Fig. 4 is divided into two circuit boards, and the circuit boards are housed in a housing partitioned into chambers by a shield wall. The housing also houses control circuits that control the first and second selectors 51 and 52. The division of the circuit and the arrangement of the control circuits will be described with reference to Fig. 5.

Fig. 5 is a cross-sectional view of a housing 60 having a shield wall 60a at the center thereof, and the housing 60 is partitioned into upper and lower chambers 60b and 60c. In the chambers 60b and 60c, circuit boards are disposed with the shield wall 60a therebetween on the wall surfaces. Fig. 5 illustrates the circuit structure on the circuit boards, although the circuit boards are not shown. A waveguide (not shown) for receiving satellite waves is connected to the upper chamber 60b.

The circuit components formed on the circuit board disposed in the upper chamber 60b are: the first and second low-noise amplifiers 33 and 35, the first and second splitters 34 and 36, the first and second mixers 37 and 38, the first local oscillator 41, the first and second IF amplifiers 43 and 44, the third and fourth splitters 47 and 48, and the first signal selector 51.

The remaining circuit components are formed on the circuit board disposed in the lower chamber 60c, that is, the third and fourth mixers 39 and 40, the second local oscillator 42, the third and fourth IF amplifiers 45 and 46, the fifth and sixth splitters 49 and 50, and the second signal selector 52. In this manner, more circuit components (the first and second low-noise amplifiers 33 and 35 and the first and second splitters 34 and 36) are mounted on the circuit board disposed in the upper chamber 60b than on the circuit board disposed in the lower chamber 60c because of the waveguide for receiving satellite waves connected to the upper chamber 60b. A control circuit 61 for controlling the first signal selector 51 and a control circuit 62 for controlling the second signal selector 52 are formed on the circuit board disposed in the lower chamber 60c.

The shield wall 60a has a plurality of relay pins 63 for connection between the circuit components formed on the circuit board disposed in the upper chamber 60b and the circuit components formed on the circuit board disposed in the lower chamber 60c. Signals for signal selection are input to the output terminals 53 and 54 from an externally connected receiver. The signal input to the second output terminal 54 is input to the second control circuit 62, and four switching signals are output from the second control circuit 62 to the second signal selector 52. The second signal selector 52 selects one of the four input IF signals.

The signal input to the first output terminal 53 is introduced into the lower chamber 60c via a relay pin 63a, and is input to the first control circuit 61. Four control signals output from the first control circuit 61 are introduced into the upper chamber 60b via relay pins 63b through 63e, respectively, and are input to the first signal selector 51. The first signal selector 51 selects one of the four input IF signals.

The chambers 60b and 60c are covered by covers 64 and 65, respectively.

In the related art, a shield wall by which the upper and lower chambers are partitioned must have multiple relay pins for connection between the circuit components disposed in the upper chamber and the circuit components disposed in the lower chamber. A problem occurs in that the cost of the components increases and the mounting operation is bothersome.

### SUMMARY OF THE INVENTION

Accordingly, it is an object of the present invention to provide a simple connection between circuit components disposed in different chambers, thus reducing the number of relay connection pins on a shield wall that partitions the chambers.

According to the present invention, a down converter for satellite broadcast reception includes a housing having first and second chambers partitioned by a shield wall, a first signal selector disposed in the first chamber, a second signal selector disposed in the second chamber, and first and second control circuits disposed in the first chamber. The first signal selector receives a low-frequency IF signal generated in the first chamber and a high-frequency IF signal generated in the second chamber, and selectively outputs one of the IF signals. The second signal selector receives the low-frequency IF signal and the high-frequency IF signal, and selectively outputs one of the IF signals. The first control circuit outputs a control signal for controlling the first signal selector, and the second control circuit outputs a control signal for controlling the second signal selector. The shield wall has a relay pin via which the low-frequency IF signal is input to the second signal selector, and a relay pin via which the high-frequency IF signal is input to the first signal selector. The control signal output from the first control circuit is input to the first signal selector via the relay pins.

The relay pins are therefore shared for transmission of the IF signals and transmission of the control signals, thus reducing the number of relay pins.

A DC cut capacitor may be connected between an input terminal of each of the first and second signal selectors for the IF signals and each of the relay pins. The DC cut capacitor prevents the control signals from entering the first and second signal selectors.

### BRIEF DESCRIPTION OF THE DRAWINGS

Fig. 1 is a circuit diagram of a down converter for satellite broadcast reception according to the present invention;
Fig. 2 is a connection diagram of the down converter of the present invention, which is housed in a housing;
Fig. 3 is a perspective view of a relay pin of the down converter of the present invention;
Fig. 4 is a circuit diagram of a down converter for satellite broadcast reception of the related art; and
Fig. 5 is a connection diagram of the down converter of the related art.

### DESCRIPTION OF THE PREFERRED EMBODIMENTS

A down converter for satellite broadcast reception (hereinafter referred to simply as a "down converter") of the present invention will now be described with reference to the drawings.

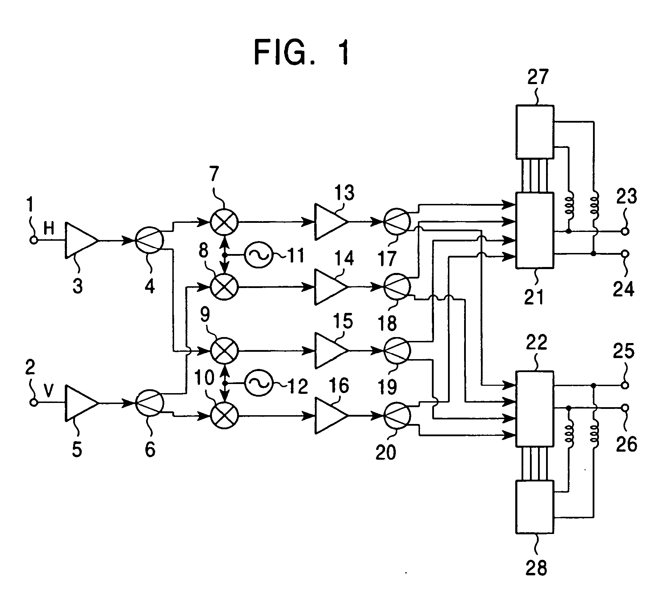

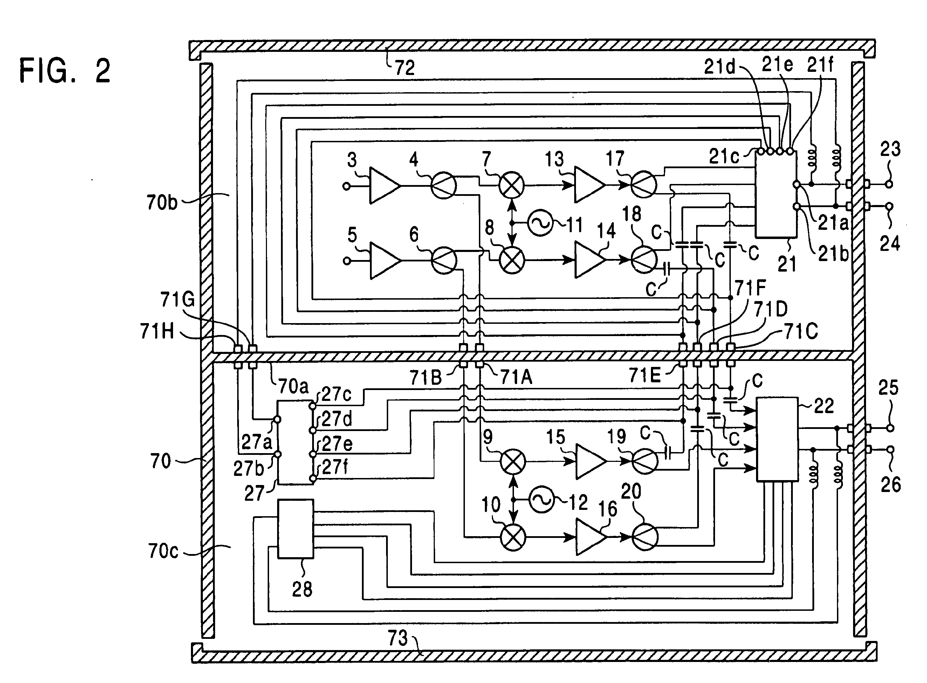

Fig. 1 is a circuit diagram of the down converter, Fig. 2 is a circuit connection diagram of the down converter, which is housed in a housing, and Fig. 3 is a perspective view of a relay pin employed in the present invention.

In Fig. 1, out of the satellite broadcasting signals in the 10.7 GHz to 12.75 GHz band received by a parabolic antenna (not shown), a horizontally-polarized satellite broadcasting signal H is input to a first input terminal 1. A vertically-polarized satellite broadcasting signal V is input to a second input terminal 2.

The first input terminal 1 is connected with a first low-noise amplifier 3, and the output terminal of the first low-noise amplifier 3 is connected with a first splitter 4. The second input terminal 2 is connected with a second low-noise amplifier 5, and the output terminal of the second low-noise amplifier 5 is connected with a second splitter 6. One horizontally-polarized satellite broadcasting signal, which is split by the first splitter 4, is input to a first mixer 7, and the other is input to a third mixer 9. One vertically-polarized satellite broadcasting signal, which is split by the second splitter 6, is input to a second mixer 8, and the other is input to a fourth mixer 10.

A first local oscillation signal of 9.75 GHz output from a first local oscillator 11 is input to both the first and second mixers 7 and 8, and a second local oscillation signal of 10.6 GHz output from a second local oscillator 12 is input to both the third and fourth mixers 9 and 10. In the first mixer 7, a horizontally-polarized satellite broadcasting signal in a low-frequency region (10.7 GHz to 11.7 GHz) of the 10.7 GHz to 12.75 GHz band is frequency-converted into a first intermediate-frequency (IF) signal ranging from 0.95 GHz to 1.95 GHz. Also, in the second mixer 8, a vertically-polarized satellite broadcasting signal in a low-frequency region (10.7 GHz to 11.7 GHz) is frequency-converted into a second IF signal ranging from 0.95 GHz to 1.95 GHz. The first and second IF signals are a low-frequency IF signals.

In the third mixer 9, a horizontally-polarized satellite broadcasting signal in a high-frequency region (11.7 GHz to 12.75 GHz) is frequency-converted into a third IF signal ranging from 1.1 GHz to 2.15 GHz. Also, in the fourth mixer 10, a vertically-polarized satellite broadcasting signal in a high-frequency region (11.7 GHz to 12.75 GHz) is frequency-converted into a fourth IF signal ranging from 1.1 GHz to 2.15 GHz. The third and fourth IF signals are high-frequency IF signals.

The first through fourth IF signals pass through bandpass filters (not shown), and are input to first through fourth IF amplifiers 13 through 16, respectively. The output terminals of the first through fourth IF amplifiers 13 through 16 are connected with third through sixth splitters 17 through 20, respectively. One of each of the first through fourth IF signals respectively output from the splitters 17 through 20 is input to a first signal selector 21, and the other is input to a second signal selector 22.

The first signal selector 21 has two output terminals 23 and 24, and individually selects and outputs one of the first through fourth IF signals to each of the output terminals 23 and 24. The second signal selector 22 also has two output terminals 25 and 26, and individually selects and outputs one of the first through fourth IF signals to each of the output terminals 25 and 26. Each of the output terminals 23 through 26 is connected to an indoor receiver (not shown) via a cable.

A selection signal for selecting an IF signal is sent from the receiver to each of the output terminals 23 through 26 via the cable. The selection signals are input to first and second control circuits 27 and 28, respectively.

The first control circuit 27 outputs to the first signal selector 21 a control signal (DC voltage) indicating which IF signal is to be selected based on the selection signal input to the output terminal 23. The first control circuit 27 further outputs to the first signal selector 21 a control signal (DC voltage) indicating which IF signal is to be selected based on the selection signal input to the output terminal 24. Therefore, the selected IF signals are individually output to the output terminals 23 and 24.

The second control circuit 28 outputs to the second signal selector 22 a control signal (DC voltage) indicating which IF signal is to be selected based on the selection signal input to the output terminal 25. The second control circuit 28 further outputs to the second signal selector 22 a control signal (DC voltage) indicating which IF signal is to be selected based on the selection signal input to the output terminal 26. Therefore, the selected IF signals are individually output to the output terminals 25 and 26.

The circuit components described above are divided into two circuit boards. The circuit boards are housed in a housing, which is partitioned by a shield wall into chambers. Fig. 2 is a cross-sectional view of a housing 70 having a shield wall 70a at the center thereof, and the housing 70 is partitioned into upper and lower chambers 70b and 70c. In the chambers 70b and 70c, circuit boards are disposed with the shield wall 70a therebetween on the wall surfaces. Fig. 2 illustrates the circuit structure on the circuit boards, although the circuit boards are not shown. A waveguide (not shown) for receiving satellite waves is connected to the upper chamber 70b.

The circuit components formed on the circuit board disposed in the upper chamber 70b are: the first and second low-noise amplifiers 3 and 5, the first and second splitters 4 and 6, the first and second mixers 7 and 8, the first local oscillator 11, the first and second IF amplifiers 13 and 14, the third and fourth splitters 17 and 18, and the first signal selector 21.

The remaining circuit components are formed on the circuit board disposed in the lower chamber 70c, that is, the third and fourth mixers 9 and 10, the second local oscillator 12, the third and fourth IF amplifiers 15 and 16, the fifth and sixth splitters 19 and 20, and the second signal selector 22. The first and second control circuits 27 and 28 are formed on the circuit board disposed in the lower chamber 70c. The chambers 70b and 70c are covered by covers 72 and 73, respectively.

The shield wall 70a has a plurality of relay pins 71, shown in Fig. 3, for connection between the circuit components formed on the circuit board disposed in the upper chamber 70b and the circuit components formed on the circuit board disposed in the lower chamber 70c. As shown in Fig. 3, each relay pin 71 is configured such that a conductor 71b is inserted along the axis of an insulating cylinder 71a, and the relay pins 71 are inserted into holes formed in the shield wall 70a.

The first splitter 4 and the third mixer 9 are connected to each other via a relay pin 71A, and the second splitter 6 and the fourth mixer 10 are connected to each other via a relay pin 71B. The third splitter 17 and the second signal selector 22 are connected to each other via a relay pin 71C, and the fourth splitter 18 and the second signal selector 22 are connected to each other via a relay pin 71D. The fifth splitter 19 and the first signal selector 21 are connected to each other via a relay pin 71E, and the sixth splitter 20 and the first signal selector 21 are connected to each other via a relay pin 71F.

Since the first control circuit 27 that controls the first signal selector 21 is disposed in the lower chamber 70c, an output terminal 21a of the first signal selector 21 is connected to a selection-signal input terminal 27a of the first control circuit 27 via a rely pin 71G, and another output terminal 21b of the first signal selector 21 is connected to another selection-signal input terminal 27b of the first control circuit 27 via a relay pin 71H so that the selection signals input to the output terminals 23 and 24 are input to the first control circuit 27. Control-signal output terminals 27c through 27f of the first control circuit 27 that output four control signals are connected to the relay pins 71C, 71D, 71F, and 71E, respectively. The relay pins 71C, 71D, 71F, and 71E are also connected to control-signal input terminals 21c through 21f of the first signal selector 21, respectively.

The selection signals input to the output terminal 23 and 24 are input to the first control circuit 27 via the relay pins 71G and 71H, respectively. The control signals output from the first control circuit 27 are input to the first signal selector 21 via the relay pins 71C, 71D, 71F, and 71E, respectively. Accordingly, the relay pins 71C through 71F are shared for transmission of the IF signals and the control signals. In the relay pins 71C through 71F, the control signals are superimposed on the IF signals to be input to the first and second signal selectors 21 and 22. Thus, DC cut capacitors C are connected between the relay pins 71C through 71F and the splitters 17 through 20 and between the relay pins 71C through 71F and the first and second signal selectors 21 and 22 in order to prevent the control signals from entering the first and second signal selector 21 and 22 and from entering the third through sixth splitters 17 through 20.

## Claims

1. A down converter for satellite broadcast reception, comprising:
a housing (70) having first and second chambers (70B,70C) partitioned by a shield wall; (70A)
first signal-selecting means (21), disposed in the first chamber (70B), that receives a low-frequency intermediate-frequency signal generated in the first chamber (70B) and a high-frequency intermediate-frequency signal generated in the second chamber (70C) and that selectively outputs one of the intermediate-frequency signals;
second signal-selecting means (22), disposed in the second chamber (70C), that receives the low-frequency intermediate-frequency signal and the high-frequency intermediate-frequency signal and that selectively outputs one of the intermediate-frequency signals
a first control circuit (27), disposed in the second chamber (70C), that outputs a control signal for controlling the first signal-selecting means (21), and
a second control circuit (28), disposed in the second chamber (70C), that outputs a control signal for controlling the second signal-selecting means (22),
wherein the shield wall (70A) has a relay pin (71C, 71D) via which the low-frequency intermediate-frequency signal is input to the second signal-selecting means (22), and a relay pin (71E,71F) via which the high-frequency intermediate-frequency signal is input to the first signal-selecting means (21), and
the control signal output from the first control circuit (27) is input to the first signal-selecting means (21) via the relay pins (71C-71F).

2. A down converter for satellite broadcast reception according to Claim 1, wherein a DC cut capacitor (C) is connected between an input terminal of each of the first and second signal-selecting means (21,22) for the intermediate-frequency signals and each of the relay pins (71C-71F).

## Patentansprüche

1. Frequenzabwärtsumsetzer für Satellitenrundfunkempfang, aufweisend:
ein Gehäuse (70), das eine erste und eine zweite Kammer (70B, 70C) hat, unterteilt durch eine Abschirmwand (70A);
eine in der ersten Kammer (70B) angeordnete erste Signalauswahleinrichtung (21), die ein in der ersten Kammer (70B) erzeugtes Niedrigfrequenz-Zwischenfrequenzsignal und ein in der zweiten Kammer (70c) erzeugtes Hochfrequenz-Zwischenfrequenzsignal empfängt und die selektiv eines der Zwischenfrequenzsignale ausgibt;
eine in der zweiten Kammer (70C) angeordnete zweite Signalauswahleinrichtung (22), die das Niedrigfrequenz-Zwischenfrequenzsignal und das Hochfrequenz-Zwischenfrequenzsignal empfängt und die selektiv eines der Zwischenfrequenzsignale ausgibt;
eine in der zweiten Kammer (70C) angeordnete erste Steuerschaltung (27), die ein Steuersignal zur Steuerung der ersten Signalauswahleinrichtung (21) ausgibt; und
eine in der zweiten Kammer (70C) angeordnete zweite Steuerschaltung (28), die ein Steuersignal zur Steuerung der zweiten Signalauswahleinrichtung (22) ausgibt;
wobei die Abschirmwand (70A) einen Relaisstift (71C, 71D) hat, über den das Niedrigfrequenz-Zwischenfrequenzsignal der zweiten Signalauswahleinrichtung (22) zugeführt wird, und einen Relaisstift (71E, 71F), über den das Hochfrequenz-Zwischenfrequenzsignal der ersten Signalauswahleinrichtung (21) zugeführt wird; und
das von der ersten Steuerschaltung (27) ausgegebene Steuersignal über die Relaisstifte (71C-71F) der ersten Signalauswahleinrichtung (21) zugeführt wird.

2. Frequenzabwärtsumsetzer für Satellitenrundfunkempfang nach Anspruch 1, wobei zwischen einen Eingangsanschluss sowohl der ersten als auch der zweiten Signalauswahleinrichtung (21,22) für die Zwischenfrequenzsignale und jeden der Relaisstifte (71C-71F) ein Gleichstrom-Sperr-Kondensator (C) geschaltet ist.

## Revendications

1. Convertisseur-abaisseur de fréquence pour réception de radiodiffusion par satellite, comprenant :
un boîtier (70) comportant des première et deuxième chambres (70B, 70C) séparées par une paroi de blindage (70A) ;
un premier moyen de sélection de signal (21), placé dans la première chambre (70B), qui reçoit un signal à fréquence intermédiaire basse fréquence généré dans la première chambre (70B) et un signal à fréquence intermédiaire haute fréquence généré dans la deuxième chambre (70C) et qui délivre sélectivement en sortie l'un des signaux à fréquence intermédiaire ;
un deuxième moyen de sélection de signal (22), placé dans la deuxième chambre (70C), qui reçoit le signal à fréquence intermédiaire basse et le signal à fréquence intermédiaire haute fréquence et qui délivre sélectivement en sortie l'un des signaux à fréquence intermédiaire ;
un premier circuit de commande (27), placé dans la deuxième chambre (70C), qui délivre en sortie un signal de commande pour commander le premier moyen de sélection de signal (21) ; et
un deuxième circuit de commande (28), placé dans la deuxième chambre (70C), qui délivre en sortie un signal de commande pour commander le deuxième moyen de sélection de signal (22) ;
dans lequel la paroi de blindage (70A) comporte une broche de relais (71C, 71D) par laquelle le signal à fréquence intermédiaire basse fréquence est transmis au deuxième moyen de sélection de signal (22), et une broche de relais (71E, 71F) par laquelle le signal à fréquence intermédiaire haute fréquence est transmis au premier moyen de sélection de signal (21) ; et
le signal de commande délivré par le premier circuit de commande (27) est transmis au premier moyen de sélection de signal (21) via les broches de relais (71C-71F).

2. Convertisseur-abaisseur de fréquence pour réception de radiodiffusion par satellite selon la revendication 1, dans lequel un condensateur de découplage continu (C) est connecté entre une borne d'entrée de chacun des premier et deuxième moyens de sélection de signal (21, 22) pour les signaux à fréquence intermédiaire et chacune des broches de relais (71C-71F).
